# EUROPEAN PATENT SPECIFICATION

(11) **EP 3 531 524 B1**
(45) Date of publication and mention of the grant of the patent: **25.11.2026**
(21) Application number: 19159331.8
(22) Date of filing: 26.02.2019
(51) Int. Cl.: H02H 7/26

(54) **HIGH SPEED PROTECTION OF POWER TRANSMISSION LINES**
HOCHGESCHWINDIGKEITSSCHUTZ VON STROMÜBERTRAGUNGSLEITUNGEN
PROTECTION À GRANDE VITESSE DE LIGNES DE TRANSMISSION DE PUISSANCE

(30) Priority: 27.02.2018 US 201815906486
(43) Date of publication of application: 28.08.2019
(73) Proprietor: Hitachi Energy Ltd, 8050 Zürich (CH)
(72) Inventor: NUQUI, Reynaldo, Cary, NC 27513 (US)
(74) Representative: Epping - Hermann - Fischer

(56) References cited:
- CN-A- 102 780 212
- US-A- 4 183 072
- US-A- 4 438 475
- US-A1- 2017 117 701

## Description

### TECHNICAL FIELD

The present application generally relates to high speed detection of transmission line faults and more particularly, but not exclusively to fault identification and protection based on metallic modal components and ground modal components of a traveling wave generated by the fault.

### BACKGROUND

Faults such as those generated by short circuits in high voltage electrical power transmission lines can cause overloading and thermal failures in the electrical network. If not detected quickly, a fault can bring the electrical system down in a matter of seconds. Present solutions for detecting and isolating such faults require a large number data points to be taken and transmitted to an electronic control processor to analyze the data and perform prepressing calculations such as Fourier Transform calculations or the like prior to determining whether a fault has occurred. These analyses take valuable time during which failures in the system may occur. Accordingly, there remains a need for further contributions in this area of technology.

US 4,438,475 concerns a protective relay apparatus and method for determining the faulted phase conductor of a three-phase ac electrical transmission line. The voltage and current on each conductor are measured and the steady-state ac electric power signal removed. The resulting filtered-voltage signals are multiplied by the characteristic admittance of the transmission line and then combined with the filtered-current signals to produce three current signals representative of the current on each conductor caused by an incident traveling wave and three current signals representative of the current on each conductor caused by a forward traveling wave. A comparator compares the six current signals to provide an indication of the direction to the fault and to provide an enable signal when the fault is on the protected line segment. The three incident-wave current signals are filtered to provide a modal signal representing the total current produced on the transmission line by a first propagational mode of the incident traveling wave. A discriminator processes the three incident-wave signals, the modal signal, and the enable signal to provide an indication of the faulted phase conductor.

US 4,183,072 concerns a protective relaying system including a protected AC transmission line and detection means for detecting a change in propagation mode of a traveling wave propagating along the transmission line. The transmission line has a pair of line ends and a surge propagation timer. The detection means is effective for comparing a value of the traveling wave as it passes one of the line ends and a value of the traveling wave as it passes the other of the line ends at a time after the surge propagation time has elapsed for detecting a change in wave value resulting from a change in wave propagation mode.

### SUMMARY

The present invention concerns a system according to claim 1 and a method according to claim 12.

One embodiment of the present application is a unique system to detect and isolate a fault in a high voltage power transmission line. Other embodiments include apparatuses, systems, devices, hardware, methods, and combinations for detecting faults in a power transmission line that includes detection of metallic mode traveling waves and ground mode traveling waves generated by a short circuit or the like. Further embodiments, forms, features, aspects, benefits, and advantages of the present application shall become apparent from the description and figures provided herewith.

### BRIEF DESCRIPTION OF THE FIGURES

Fig. 1A is a schematic view of an exemplary power transmission system with a three phase conductor overhead arrangement;
Fig. 1B is a table illustrating voltage waves generated by a fault in the conductors shown in Fig. 1A;
Fig. 2 is an exemplary graph of traveling voltage waves induced by a negative voltage pulse input into the phase A conductor;
Fig. 3 is an exemplary graph of traveling voltage waves induced by a positive voltage pulse input into the phase A conductor;
Fig. 4 is an exemplary graph of traveling voltage waves induced by a negative voltage pulse input into the phase B conductor;
Fig. 5A is a flow chart illustrating a control algorithm for the phase A conductor;
Fig. 5B is a flow chart illustrating a control algorithm for the phase B conductor; and
Fig. 5C is a flow chart illustrating a control algorithm for the phase C conductor.

### DETAILED DESCRIPTION OF THE ILLUSTRATIVE EMBODIMENTS

For the purposes of promoting an understanding of the principles of the application, reference will now be made to the embodiments illustrated in the drawings and specific language will be used to describe the same. It will nevertheless be understood that no limitation of the scope of the application is thereby intended. Any alterations and further modifications in the described embodiments, and any further applications of the principles of the application as described herein are contemplated as would normally occur to one skilled in the art to which the application relates.

Power systems are being pushed towards their operating limits due to load growth, delay in entry of new transmission lines and entry of variable energy resources. Stability limits are being approached requiring improved control and faster protection.

In the latter, faster and more secure protection methods and systems must be developed to address these challenges. High voltage transmission line protection must take advantage of increased availability of high sampling signal processing systems to increase the speed of protection. This invention takes advantage of high sampling technology to sample high frequency transients particularly traveling waves. An algorithm that quickly makes decisions on the existence of a fault based on a few samples of the incident traveling wave is a clear differentiator in the AC protection market that is dominated by relatively slower sampling rates.

When a fault occurs, it will generate voltage traveling waves in all conductors. Each of these traveling waves can be decomposed into its equivalent "modal" voltages using modal transformation. In a three conductor untransposed system, it was confirmed by theory and simulation that there are (three modes) of traveling waves. Two of these modes are metallic modes referred to as Metallic Mode 1 (MM1) and Metallic Mode 2 (MM2); the third mode is a ground mode referred here as Ground Mode 0 (GM0. The GM0 is present in all conductors and flows through ground. MM1 travels in the metallic path through all of the phase conductors. MM2 travels only in the outer conductors (B and C). MM1 travels the fastest of the three waves with a speed approaching the speed of light in overhead conductors. MM2 travels at a slower rate of speed to that of MM1. The GM0 travels slower than either MM1 or MM2. It should be noted that traveling waves travel at a slower speed in non-overhead cables, however the relative speeds of travel of the are proportional to that of overhead conductors.

The modal voltages *Eₘ* are related to the phase voltages *E* through the voltage transformation matrix *[Tₑ]* according to the relationship $E = \left[{T}_{e}\right] {E}_{m}$ (1)

Similarly, the modal currents /ₘ are related to the phase currents I through the current transformation matrix *[Tᵢ]* according to the relationship $I = \left[{T}_{i}\right] {I}_{im}$ (2)

Conversely, the phase voltages *E* are related to modal voltages *Eₘ* through the inverse of the voltage transformation matrix [Tₑ]⁻¹ = [Te,inv] according to the relationship $Em = \left[{T}_{e , inv}\right] E$ (3)

The phase currents / are related to modal currents /ₘ through the inverse of the current transformation matrix *[Ti]⁻¹ = [T₁,ᵢₙᵥ]* according to the relationship ${I}_{m} = \left[{T}_{inv}\right] I$ (4)

When the system is excited in the phase domain with fault voltage *E_{f}* in one conductor, then correspondingly the system is excited in the modal domain. For example, during a positive pole to ground fault in a three conductor system with conductor arranged in sequence of positive pole, metallic return, and negative pole, the fault voltage *[E_{f}*0 0] will excite a vector of fault modal voltages of [E_{m,0}, E_{m,1.} Eₘ,₂] corresponding to GMO, MM1, and MM2 excitation voltage so the excited modal voltages can be determined at the point of a fault using the inverse of the voltage transformation matrix.

When the traveling wave arrives at the station, the magnitude of these same exciting modal voltages are determined from the measured phase voltages. At that time, due to surge impedance of the overhead transmission line the amplitude of these voltages will have decreased when they reach the station. A fault will produce traveling waves in all conductors. The magnitude of the wave on the faulted phase typically results in the wave with the highest magnitude.

The voltage traveling wave at the faulted phase will arrive at the station with a polarity equal to that of the impressed voltage at the fault point. A fault in the outer conductors (Phase A & C) includes the superposition of the two metallic modes MM1 and MM2. A fault in the middle conductor (Phase B) generated only a MM1 wave. The direction of the other voltage wave arriving at the station from the unfaulted phases will be opposite in polarity.

A protection function designed for the metallic modal waves can occur with a fast sampling rate fault detection in approximately 10 microseconds after the initial wave is detected at the station. The speed of the fault detection can be equivalent to the speed of the incident traveling wave of voltage or current arriving at the station. In three phase overhead lines for example, the traveling wave travels at close to the speed of light.

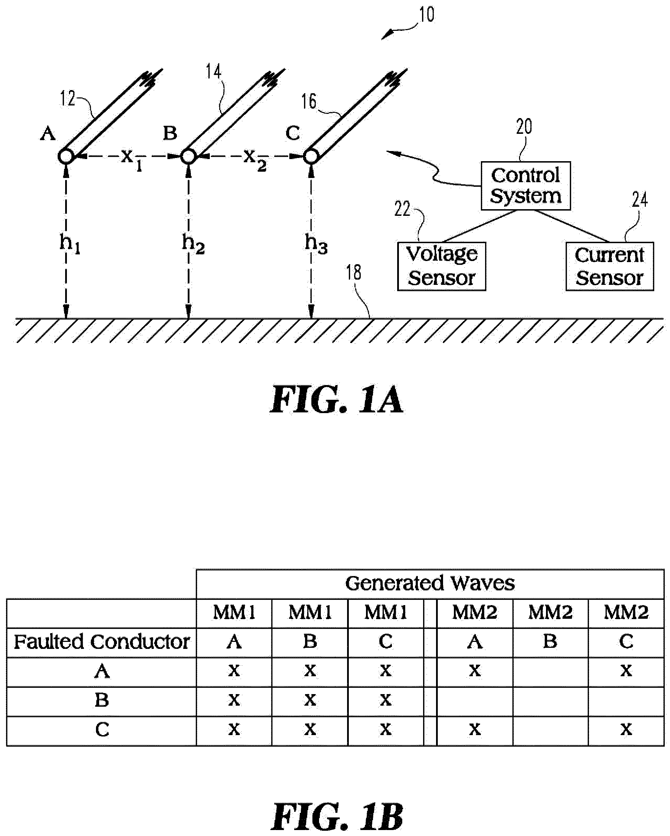

Referring to Fig. 1, a three phase power transmission system 10 is illustrated in schematic form. The three phase power transmission system 10 includes a first conductor line 12, a second conductor line 14 and a third conductor line 16 corresponding to Phase A, Phase B, and Phase C, respectively. The conductor lines 12, 14 and 16 are operable to transmit electrical power from a power source to an electrical load. The power source can include power generation from standard means such as hydro generators or the like as well as alternative sources such as solar and wind power or the like. The first conductor 12 can be positioned at a height h₁ above a ground 18, the second conductor can be positioned at a height h₂ above the ground 18 and the third conductor can be positioned at a height h₃ above the ground 18. In one form, each of the heights h₁, h₂ and h₃ can be substantially equivalent to one another, however in other forms, the heights can vary with respect to one another. Further, a distance X₁ defined between the first conductor 12 and the second conductor 14 and a distance X₂ defined between the second conductor line 14 and the third conductor can be substantially equivalent to one another. However in other forms, the distances X₁ and X₂ may be varied depending upon the requirement of the power transmission application. Furthermore, in some forms the first conductor 12, a second conductor 14 and a third conductor 16 may be positioned in a non-linear orientation. The power transmission system 10 may include a control system 20 operable for controlling the electric power that is conducted through each of the conductors 12, 14 and 16. The control system 20 can include an electronic controller, a memory, sensors, communications lines, and other electronic components as one skilled in the art would understand. The sensors can include a voltage sensor 22 and current sensor 24. Other types of sensors may be utilized by the control system 20 such as temperature sensors, or the like. When a fault occurs in one of the conductor lines 12, 14 or 16, due to various causes such as a short circuit or the like, one or more travelling waves are generated through the conductors 12, 14 or 16.

Referring now to Fig. 1B, a table illustrating a faulted conductor, either conductor A, conductor B or conductor C and the voltage waves generated in each of the conductors as a function of the faulted conductor. When a fault occurs in conductor A, a MM1 wave is generated in each of the conductors A, B and C, and a MM2 wave is generated through only conductor A and Conductor C. Although not shown, a fault will generate a relatively slow GM0 wave in each conductor 12, 14 and 16. When a fault is generated in conductor B, a MM1 wave is generated in each of these line conductors A, B and C, however there are no MM2 voltage generated waves in any of the conductors A, B or C. When a fault is generated in conductor C, each of the conductors A, B or C will propagate an MM1 wave therethrough and a MM2 wave is generated in conductor A and conductor C, however no MM2 waves are generated in conductor B.

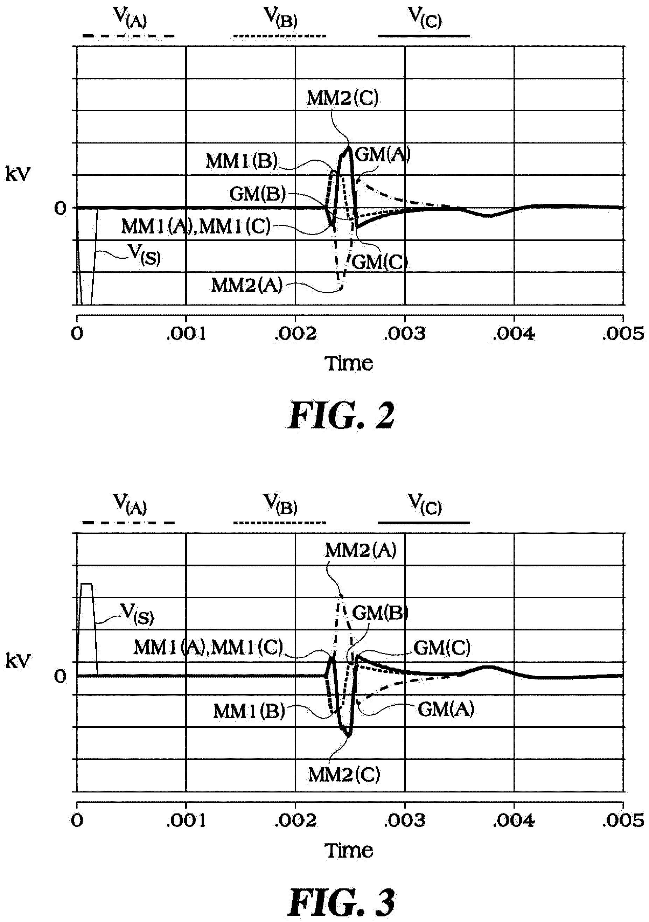

Referring now to Figs. 2 and 3, voltage waves are generated in line measurements A, B, and C for a phase-A pulse voltage input generated at the fault location 600 kilometers away. The phase voltage can be generated by a fault in line 12 (Fig. 1A) such as an open circuit or a short circuit. As explained above, the modal voltage traveling waves move at different speeds. MM1 waves move the fastest, followed by MM2 waves and slowest being GM0 waves. The traveling waves in Fig. 2 result from a negative voltage pulse V₍ₛ₎ input at the fault location corresponding to a fault during the positive half cycle. The traveling waves in Fig. 3 result from a positive voltage pulse V₍ₛ₎. In an AC system the fault voltage can either be positive or negative depending on the point on the wave when the fault occurs. The voltage spike level V₍ₛ₎ is generated by a fault located 600 km away from the major location in the first conductor line 12. A MM1, MM2 and GM0 waves generated in the first conductor line 12. A MM1 wave and a GM0 wave is generated in the second conductor line 14. A MM2 wave is generated in a third conductor line 16. A voltage pulse is generated in each of the conductors A, B and C as illustrated and can be seen that the MM1 phase in the conductors B and C travels faster than GM0. The control system 20 is operably connected to the voltage sensor 22 and the current sensor 24 and can determine which of the conducting conduits 12, 14 and 16 have a fault based on the voltage signals. The control system 20 can sense a fault as fast as 10 microseconds and then subsequently cut power off through any of the faulted conductors.

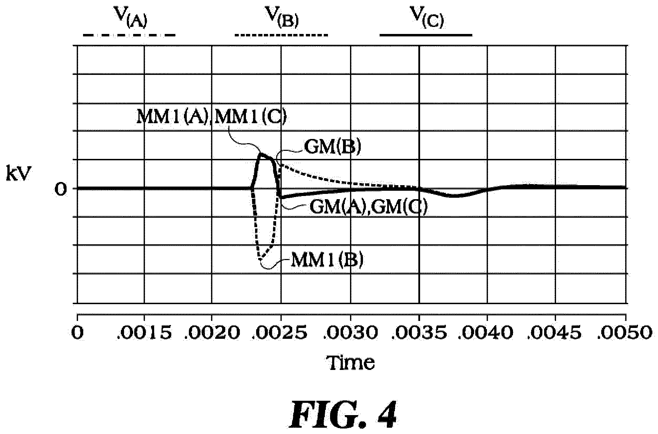

Referring now to Fig. 4, for a fault in the middle conductor line 14 or phase B, no MM2 voltage waves are generated at the fault location. Only the MM1 and the GM0 voltage waves are generated. These modal waves will travel towards the station with the MM1 wave arriving first followed by the GM0 wave as shown.

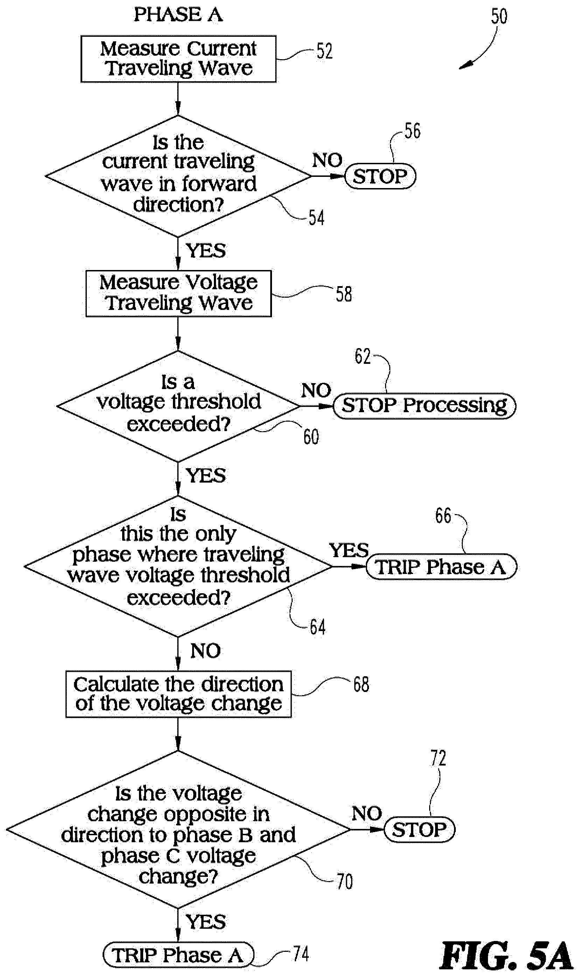

Referring to Fig. 5A, a method 50 for determining whether a fault has occurred in the Phase A conductor is illustrated. The method 50 begins at step 52 wherein a controller in a control system measures the current of a traveling wave in a first phase (Phase A) conductor. The controller system will determine at step 54 whether the traveling wave is moving in a forward direction as defined by a direction from a power source to a load. If the traveling wave is not moving in a forward direction, then the controller stops processing at step 56. If at step 54, the controller determines that the traveling wave is moving in a forward direction, then the controller proceeds to measure the voltage of the traveling wave, at step 58. If the voltage has not exceeded a predetermined threshold value, then the controller stops processing at step 62. If the voltage has exceeded a predetermined threshold value at step 60, then the controller will determine whether this is the only phase with a faulted conductor at step 64. If the answer to the query at step 64 is yes, then the controller will trip the Phase A conductor (i.e., cuts electrical power to the Phase A conductor). If the controller determines more than one phase has traveling waves that exceed a predetermined voltage threshold value level, then the controller will calculate the direction of the voltage change for each of the conductors at step 68. If at step 70, the controller determines that voltage change is in the same direction to that of the voltage change of the Phase B and Phase C conductors, then the controller stops processing at step 72. If the voltage change in Phase A is in an opposite direction to that of Phase B and Phase C, then the control system trips Phase A (i.e., cuts electrical power to the Phase A conductor) at step 74.

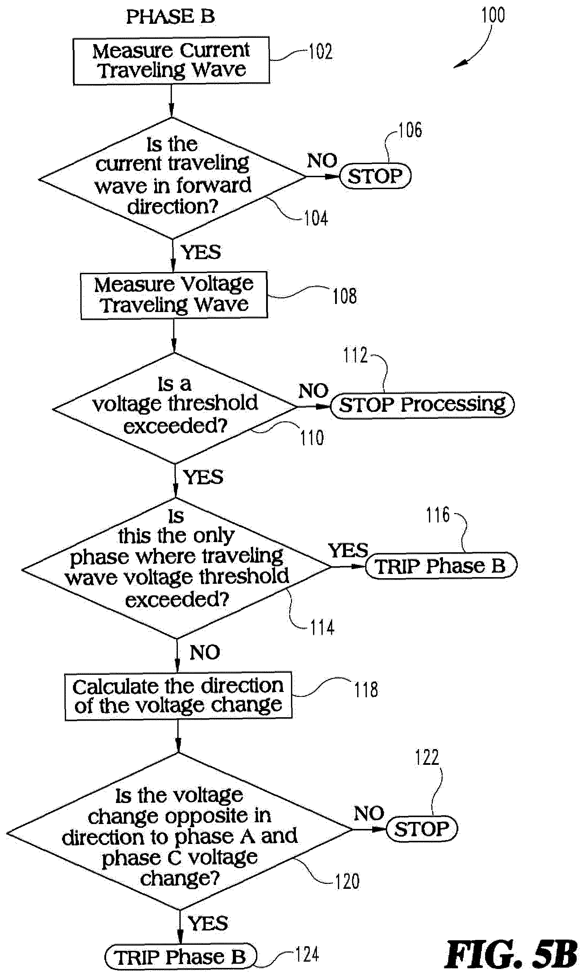

Referring to Fig. 5B, a method 100 for determining whether a fault has occurred in the Phase B conductor is illustrated. The method 100 begins at step 102 wherein a controller in a control system measures the current of a traveling wave in a second phase (Phase B) conductor. The controller system will determine at step 104 whether the traveling wave is moving in a forward direction as defined by a direction from a power source to a load. If the traveling wave is not moving in a forward direction, then the controller stops processing at step 106. If at step 104, the controller determines that the traveling wave is moving in a forward direction, then the controller proceeds to measure the voltage of the traveling wave, at step 108. If the voltage has not exceeded a predetermined threshold value, then the controller stops processing at step 112. If the voltage has exceeded a predetermined threshold value at step 110, then the controller will determine whether this is the only phase with a faulted conductor at step 114. If the answer to the query at step 114 is yes, then the controller will trip the Phase B conductor (i.e., cuts electrical power to the Phase B conductor). If the controller determines more than one phase has traveling waves that exceed a predetermined voltage threshold value level, then the controller will calculate the direction of the voltage change for each of the conductors at step 118. If at step 120, the controller determines that voltage change is in the same direction to that of the voltage change of the Phase A and Phase C conductors, then the controller stops processing at step 122. If the voltage change in Phase B is in an opposite direction to that of Phase A and Phase C, then the control system trips Phase B (i.e., cuts electrical power to the Phase B conductor) at step 124.

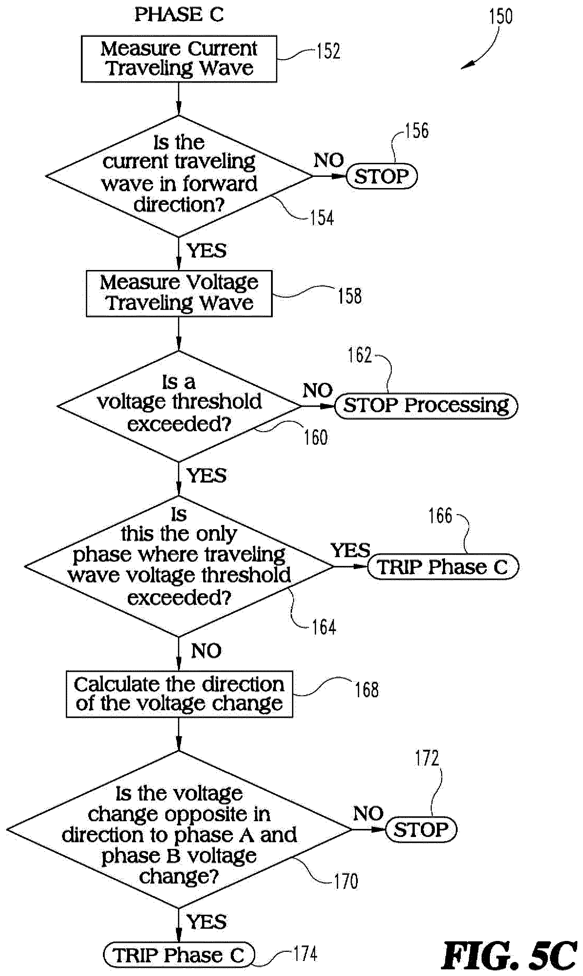

Referring to Fig. 5C, a method 150 for determining whether a fault has occurred in the Phase C conductor is illustrated. The method 150 begins at step 152 wherein a controller in a control system measures the current of a traveling wave in a third phase (Phase C) conductor. The controller system will determine at step 154 whether the traveling wave is moving in a forward direction as defined by a direction from a power source to a load. If the traveling wave is not moving in a forward direction, then the controller stops processing at step 156. If at step 154, the controller determines that the traveling wave is moving in a forward direction, then the controller proceeds to measure the voltage of the traveling wave, at step 158. If the voltage has not exceeded a predetermined threshold value, then the controller stops processing at step 162. If the voltage has exceeded a predetermined threshold value at step 160, then the controller will determine whether this is the only phase with a faulted conductor at step 164. If the answer to the query at step 164 is yes, then the controller will trip the Phase C conductor (i.e., cuts electrical power to the Phase C conductor). If the controller determines more than one phase has traveling waves that exceed a predetermined voltage threshold value level, then the controller will calculate the direction of the voltage change for each of the conductors at step 168. If at step 170, the controller determines that voltage change is in the same direction to that of the voltage change of the Phase A and Phase B conductors, then the controller stops processing at step 172. If the voltage change in Phase C is in an opposite direction to that of Phase A and Phase B, then the control system trips Phase C (i.e., cuts electrical power to the Phase C conductor) at step 174.

In one aspect, the present disclosure includes a system comprising: a three phase power transmission system including a first conductor line, a second conductor line and a third conductor line; one or more sensors configured to detect traveling waves in each of the first second and third conductors; a controller operable for receiving data transmitted by the one or more sensors and determining which of the traveling modal waves is a first metallic mode wave, a second metallic mode wave and/or a ground mode wave; and wherein the controller is operable to determine which of the conductor lines are faulted based on detection of one or more of first metallic mode waves, second metallic mode waves and/or ground mode waves.

In refining aspects, the one or more sensors are voltage sensors; wherein the one or more sensors are current sensors; wherein a transmission speed of the first metallic mode is greater than the second metallic mode; wherein a transmission speed of the ground mode is slower than the second metallic mode; wherein the first and third conductor lines are outer lines and the second conductor line is an intermediate line positioned between the first and third conductor lines; wherein the first and third conductor lines transmit waves having opposite polarities; wherein the second metallic mode wave travels only through the first and third conductor lines; wherein the first metallic mode wave travels through each of the first, second and third conductor lines; wherein the ground mode travels through each of the first, second and third conductor lines; wherein the controller operable to identify a faulted line without prior processing of data transmitted by the sensors; and wherein the controller is configured to determine a faulted conductor line upon detection of a first metallic mode wave.

Another aspect of the present disclosure includes a method comprising: sensing a current traveling wave in a first conductor line, a second conductor line and a third conductor line of a three phase system; determining whether the current traveling wave is moving in a forward direction in the first conductor line, the second conductor line and the third conductor line; sensing a voltage traveling wave in the first conductor line, the second conductor line and the third conductor line; and shutting electrical power off to any of the conductor lines after detecting that the current traveling wave moving in the forward direction and the voltage traveling wave exceeds a predetermined threshold value.

In refining aspects, the voltage wave is generated by an electrical fault; further comprising sending a signal to shut off electrical power within 10 microseconds of the fault being detected; wherein the fault is generated by a short circuit; and wherein the traveling voltage wave is one of a metallic mode 1 traveling wave, a metallic mode 2 traveling wave and a ground mode 0 traveling wave.

Another aspect of the present disclosure includes a system comprising: first, second and third electrical conductor lines; one or more sensors configured to sense a voltage and a current flowing through the first, second and third electrical conductor lines; a controller in electrical communication with the one or more sensors; wherein the controller is operable to identify a first metallic mode wave, a second metallic mode wave and a ground mode wave generated by a fault in any of the first, second and third electrical conductor lines; and wherein the controller is further configured shut electrical power off to one or more of the first, second or third conductors when a metallic mode 1 traveling wave is detected.

In refining aspects, the controller is configured to send a signal to shut down power to a faulted conductor line within 10 microseconds of a fault being detected; and wherein the controller shuts down power to a faulted conductor line prior to performing process calculations of the sensed data.

While the application has been illustrated and described in detail in the drawings and foregoing description, the same is to be considered as illustrative and not restrictive in character, it being understood that only the preferred embodiments have been shown and described

. It should be understood that while the use of words such as preferable, preferably, preferred or more preferred utilized in the description above indicate that the feature so described may be more desirable, it nonetheless may not be necessary and embodiments lacking the same may be contemplated as within the scope of the application, the scope being defined by the claims that follow. In reading the claims, it is intended that when words such as "a," "an," "at least one," or "at least one portion" are used there is no intention to limit the claim to only one item unless specifically stated to the contrary in the claim. When the language "at least a portion" and/or "a portion" is used the item can include a portion and/or the entire item unless specifically stated to the contrary.

Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

## Claims

1. A system (10) comprising:
a three-phase power transmission system (10) including a first conductor line (12), a second conductor line (14) and a third conductor line (16);
one or more sensors (22, 24) configured to detect current and voltage traveling waves in each of the first, second and third conductor lines (12, 14, 16); and
a controller (20) operable to receive data transmitted by the one or more sensors (22,24), and to determine which of the traveling modal waves is a first metallic mode (MM1) wave, a second metallic mode (MM2) wave and/or a ground mode (GM0) wave;
**characterized in that** the controller (20) is operable to determine which of the conductor lines (12, 14, 16) are faulted based on detection of one or more of the first metallic mode (MM1) waves and the second metallic mode (MM2) waves,
wherein if the first metallic mode wave (MM1) is detected on the first, second and third conductor lines (12, 14, 16), and if the second metallic mode wave (MM2) is detected only on the first and third conductor lines (12, 16), at least one of the first and third conductor lines (12, 16) are determined to be faulted, and
wherein if the first metallic mode wave (MM1) is detected on the first, second and third conductor lines (12, 14, 16), and if the second metallic mode wave (MM2) is not detected on the first, second and third conductor lines (12, 14, 16), the second conductor line (14) is determined to be faulted; and
the controller (20) is operable to shut electrical power off to any of the conductor lines (12, 14, 16) determined to be faulted.

2. The system of claim 1, wherein the controller (20) is specifically operable to:
shut off electrical power to any of the conductor lines (12, 14, 16) determined to be faulted when determining that the voltage traveling wave exceeds a predetermined threshold value and that a current traveling wave is moving in the forward direction.

3. The system of claim 1, wherein the one or more sensors (22, 24) are at least one of voltage sensors and current sensors.

4. The system (10) of claim 1, wherein a transmission speed of the first metallic mode (MM1) is greater than the second metallic mode (MM2).

5. The system (10) of claim 4, wherein a transmission speed of the ground mode (GM0) is slower than the second metallic mode (MM2).

6. The system (10) of claim 1, wherein the first and third conductor lines (12, 16) are outer lines and the second conductor line (14) is an intermediate line positioned between the first and third conductor lines (12, 16); or
wherein the first and third conductor lines (12, 16) transmit waves having opposite polarities.

7. The system (10) of claim 1, wherein the second metallic mode (MM2) wave travels only through the first and the third conductor lines (12, 16); or
wherein the first metallic mode (MM1) wave travels through each of the first, second and third conductor lines (12, 14, 16); or
wherein the ground mode (GM0) travels through each of the first, second and third conductor lines (12, 14, 16).

8. The system (10) of claim 1, wherein the controller (20) operable to identify a faulted line without prior processing of data transmitted by the sensors (22, 24).

9. The system (10) of claim 8, wherein the controller (20) is configured to determine a faulted conductor line upon detection of a first metallic mode (MM1) wave.

10. The system (10) of claim 1, wherein
the one or more sensors (22, 24) are configured to sense a voltage and a current flowing through the first, second and third electrical conductor lines (12, 14, 16);
the controller (20) is operable to identify the first metallic mode (MM1) wave, the second metallic mode (MM2) wave and the ground mode (GM0) wave generated by a fault in any of the first, second and third electrical conductor lines (12, 14, 16);
and
the controller (20) is further configured shut electrical power off to one or more of the first, second or third conductors (12, 14, 16) when the first metallic mode (MM1) wave is detected.

11. The system of claim 10, wherein the controller (20) is configured to send a signal to shut down power to a faulted conductor line within 10 microsecond of a fault being detected; or
wherein the controller (20) is configured to shut down power to a faulted conductor line prior to performing process calculations of the sensed data.

12. A method (50, 100, 150) comprising:
sensing (60, 110, 160) at least one voltage traveling wave in a first conductor line (12), a second conductor line (14) and a third conductor line (16) of a three phase system (10); and
determine which of the voltage traveling waves is a first metallic mode (MM1) wave, a second metallic mode (MM2) wave and/or a ground mode (GM0) wave,
charachterized by
determining that at least one of the first and third conductor lines (12, 16) are faulted, if the first metallic mode wave (MM1) is detected on the first, second and third conductor lines (12, 14, 16), and if the second metallic mode wave (MM2) is detected only on the first and third conductor lines (12, 16);
determining that the second conductor line (14) is faulted, if the first metallic mode wave (MM1) is detected on the first, second and third conductor lines (12, 14, 16), and if the second metallic mode wave (MM2) is not detected on the first, second and third conductor lines (12, 14, 16); and
shutting (74, 124, 174) electrical power off to any of the conductor lines (12, 14, 16) determined to be faulted.

13. The method of claim 12, further comprising:
sensing (51, 102, 152) a current traveling wave in a first conductor line (12), a second conductor line (14) and a third conductor line (16); and
determining (54, 104, 154) whether the current traveling wave is moving in a forward direction in the first conductor line (12), the second conductor line (14) and the third conductor line (16); wherein
the electrical power to any of the conductor lines (12, 14, 16) determined to be faulted is shut off when determining (54, 104, 154) that the current traveling wave moving in the forward direction and that the voltage traveling wave exceeds a predetermined threshold value.

14. The method of claim 13 further comprising sending a signal to shut off electrical power within 10 microseconds of the fault being detected; or
wherein the fault is generated by a short circuit.

15. The method of claim 12, wherein the traveling voltage wave is one of a metallic mode 1 (MM1) traveling wave, a metallic mode 2 (MM2) traveling wave and a ground mode 0 (GM0) traveling wave.

## Patentansprüche

1. System (10), das Folgendes umfasst:
ein Dreiphasen-Energieübertragungssystem (10), das eine erste Leitung (12), eine zweite Leitung (14) und eine dritte Leitung (16) beinhaltet;
einen oder mehrere Sensoren (22, 24), die dazu ausgelegt sind, Strom- und Spannungswanderwellen jeweils in der ersten, zweiten und dritten Leitung (12, 14, 16) zu detektieren; und
eine Steuerung (20), die betreibbar ist zum Empfangen von Daten, die durch den einen oder die mehreren Sensoren (22, 24) übertragen werden, und zum Bestimmen, welche der modalen Wanderwellen eine Welle einer ersten Metallmode (MM1), eine Welle einer zweiten Metallmode (MM2) und/oder eine Welle einer Massemode (GM0) ist;
**dadurch gekennzeichnet, dass** die Steuerung (20) betreibbar ist zum Bestimmen, welche der Leitungen (12, 14, 16) fehlerhaft sind, basierend auf einer Detektion der Wellen einer ersten Metallmode (MM1) und/oder der Wellen einer zweiten Metallmode (MM2),
wobei, wenn die Welle einer ersten Metallmode (MM1) auf der ersten, zweiten und dritten Leitung (12, 14, 16) detektiert wird und wenn die Welle einer zweiten Metallmode (MM2) nur auf der ersten und dritten Leitung (12, 16) detektiert wird, bestimmt wird, dass die erste und/oder die dritte Leitung (12, 16) fehlerhaft ist, und wobei, wenn die Welle einer ersten Metallmode (MM1) auf der ersten, zweiten und dritten Leitung (12, 14, 16) detektiert wird und wenn die Welle einer zweiten Metallmode (MM2) nicht auf der ersten, zweiten und dritten Leitung (12, 14, 16) detektiert wird, bestimmt wird, dass die zweite Leitung (14) fehlerhaft ist, und
die Steuerung (20) betreibbar ist zum Abschalten der elektrischen Leistung an jegliche der Leitungen (12, 14, 16), die als fehlerhaft bestimmt werden.

2. System nach Anspruch 1, wobei die Steuerung (20) insbesondere betreibbar ist zum:
Abschalten der elektrischen Leistung an jegliche der Leitungen (12, 14, 16), die als fehlerhaft bestimmt werden, wenn bestimmt wird, dass die Spannungswanderwelle einen vorbestimmten Schwellenwert überschreitet und dass sich eine Stromwanderwelle in die Vorwärtsrichtung bewegt.

3. System nach Anspruch 1, wobei der eine oder die mehreren Sensoren (22, 24) Spannungssensoren und/oder Stromsensoren sind.

4. System (10) nach Anspruch 1, wobei eine Übertragungsgeschwindigkeit der ersten Metallmode (MM1) größer als die zweite Metallmode (MM2) ist.

5. System (10) nach Anspruch 4, wobei eine Übertragungsgeschwindigkeit der Massemode (GM0) langsamer als die zweite Metallmode (MM2) ist.

6. System (10) nach Anspruch 1, wobei die erste und die dritte Leitung (12, 16) Außenleiter sind und die zweite Leitung (14) ein Zwischenleiter ist, der zwischen der ersten und der dritten Leitung (12, 16) positioniert ist; oder
wobei die erste und die dritte Leitung (12, 16) Wellen mit entgegengesetzten Polaritäten übertragen.

7. System (10) nach Anspruch 1, wobei sich die Welle der zweiten Metallmode (MM2) nur durch die erste und die dritte Leitung (12, 16) bewegt; oder
wobei sich die Welle der ersten Metallmode (MM1) durch jede der ersten, zweiten und dritten Leitung (12, 14, 16) bewegt; oder
wobei sich die Massemode (GM0) durch jede der ersten, zweiten und dritten Leitung (12, 14, 16) bewegt.

8. System (10) nach Anspruch 1, wobei die Steuerung (20) betreibbar ist zum Identifizieren einer fehlerhaften Leitung ohne vorherige Verarbeitung von durch die Sensoren (22, 24) übertragenen Daten.

9. System (10) nach Anspruch 8, wobei die Steuerung (20) dazu ausgelegt ist, eine fehlerhafte Leitung bei Detektion einer Welle einer ersten Metallmode (MM1) zu bestimmen.

10. System (10) nach Anspruch 1, wobei
der eine oder die mehreren Sensoren (22, 24) dazu ausgelegt sind, eine Spannung und einen Strom, die durch die erste, zweite und dritte elektrische Leitung (12, 14, 16) fließen, zu erfassen;
die Steuerung (20) betreibbar ist zum Identifizieren der Welle einer ersten Metallmode (MM1), der Welle einer zweiten Metallmode (MM2) und der Welle einer Massemode (GM0), die durch einen Fehler in einer beliebigen der ersten, zweiten und dritten elektrischen Leitung (12, 14, 16) erzeugt werden;
und
die Steuerung (20) ferner dazu ausgelegt ist, die elektrische Leistung an den ersten und/oder zweiten und/oder dritten Leiter (12, 14, 16) zu trennen, wenn die Welle der ersten Metallmode (MM1) detektiert wird.

11. System nach Anspruch 10, wobei die Steuerung (20) dazu ausgelegt ist, ein Signal zum Trennen der Leistung an eine fehlerhafte Leitung innerhalb von 10 Mikrosekunden nach Detektieren eines Fehlers zu senden; oder
wobei die Steuerung (20) dazu ausgelegt ist, die Leistung an eine fehlerhafte Leitung vor Durchführen von Prozessberechnungen der erfassten Daten zu trennen.

12. Verfahren (50, 100, 150), das Folgendes umfasst:
Erfassen (60, 110, 160) mindestens einer Spannungswanderwelle in einer ersten Leitung (12), einer zweiten Leitung (14) und einer dritten Leitung (16) eines Dreiphasensystems (10); und
Bestimmen, welche der Spannungswanderwellen eine Welle einer ersten Metallmode (MM1), eine Welle einer zweiten Metallmode (MM2) und/oder eine Welle einer Massemode (GM0) ist,
**gekennzeichnet durch**
Bestimmen, dass die erste und/oder die dritte Leitung (12, 16) fehlerhaft sind, wenn die Welle einer ersten Metallmode (MM1) auf der ersten, zweiten und dritten Leitung (12, 14, 16) detektiert wird und wenn die Welle einer zweiten Metallmode (MM2) nur auf der ersten und dritten Leitung (12, 16) detektiert wird;
Bestimmen, dass die zweite Leitung (14) fehlerhaft ist, wenn die Welle einer ersten Metallmode (MM1) auf der ersten, zweiten und dritten Leitung (12, 14, 16) detektiert wird und wenn die Welle einer zweiten Metallmode (MM2) nicht auf der ersten, zweiten und dritten Leitung (12, 14, 16) detektiert wird; und
Trennen (74, 124, 174) der elektrischen Leistung an jegliche der Leitungen (12, 14, 16), die als fehlerhaft bestimmt werden.

13. Verfahren nach Anspruch 12, das ferner Folgendes umfasst:
Erfassen (51, 102, 152) einer Stromwanderwelle in einer ersten Leitung (12), einer zweiten Leitung (14) und einer dritten Leitung (16); und
Bestimmen (54, 104, 154), ob sich die Stromwanderwelle in einer Vorwärtsrichtung in der ersten Leitung (12), der zweiten Leitung (14) und der dritten Leitung (16) bewegt;
wobei
die elektrische Leistung an jegliche der Leitungen (12, 14, 16), die als fehlerhaft bestimmt werden, getrennt wird, wenn bestimmt wird (54, 104, 154), dass sich die Stromwanderwelle in der Vorwärtsrichtung bewegt und dass die Spannungswanderwelle einen vorbestimmten Schwellenwert überschreitet.

14. Verfahren nach Anspruch 13, ferner umfassend Senden eines Signals zum Trennen der elektrischen Leistung innerhalb von 10 Mikrosekunden nach Detektieren des Fehlers; oder
wobei der Fehler durch einen Kurzschluss erzeugt wird.

15. Verfahren nach Anspruch 12, wobei die Wanderspannungswelle eine Wanderwelle einer Metallmode 1 (MM1), eine Wanderwelle einer Metallmode 2 (MM2) oder eine Wanderwelle einer Massemode 0 (GM0) ist.

## Revendications

1. Système (10), comprenant :
un système de transmission d'énergie triphasé (10) comprenant une première ligne conductrice (12), une deuxième ligne conductrice (14) et une troisième ligne conductrice (16),
un ou plusieurs capteurs (22, 24) configurés pour détecter des ondes progressives de courant et de tension dans chacune des première, deuxième et troisième lignes conductrices (12, 14, 16) ; et
un dispositif de commande (20) pouvant recevoir des données transmises par le ou les capteurs (22, 24) et déterminer laquelle des ondes modales progressives est une onde de premier mode métallique (MM1), une onde de deuxième mode métallique (MM2) et/ou une onde de mode de masse (GM0) ;
**caractérisé en ce que** le dispositif de commande (20) peut être utilisé pour déterminer lesquelles des lignes conductrices (12, 14, 16) sont défaillantes sur la base de la détection d'une ou plusieurs des ondes de premier mode métallique (MM1) et des ondes de deuxième mode métallique (MM2),
si l'onde de premier mode métallique (MM1) est détectée sur les première, deuxième et troisième lignes conductrices (12, 14, 16), et si l'onde de deuxième mode métallique (MM2) est détectée uniquement sur les première et troisième lignes conductrices (12, 16), au moins une des première et troisième lignes conductrices (12, 16) étant déterminée comme étant défaillante, et
si l'onde de premier mode métallique (MM1) est détectée sur les première, deuxième et troisième lignes conductrices (12, 14, 16), et si l'onde de deuxième mode métallique (MM2) n'est pas détectée sur les première, deuxième et troisième lignes conductrices (12, 14, 16), la deuxième ligne conductrice (14) étant déterminée comme étant défaillante ; et
le dispositif de commande (20) pouvant être utilisé pour couper l'alimentation électrique de l'une quelconque des lignes conductrices (12, 14, 16) déterminée comme étant défaillante.

2. Système selon la revendication 1, le dispositif de commande (20) pouvant fonctionner spécifiquement pour :
couper l'alimentation électrique de l'une quelconque des lignes conductrices (12, 14, 16) déterminée comme étant défaillante lors de la détermination que l'onde progressive de tension dépasse une valeur seuil prédéterminée et qu'une onde progressive de courant se déplace dans la direction avant.

3. Système selon la revendication 1, le ou les capteurs (22, 24) étant au moins l'un des capteurs de tension et des capteurs de courant.

4. Système (10) selon la revendication 1, une vitesse de transmission du premier mode métallique (MM1) étant supérieure à celle du deuxième mode métallique (MM2).

5. Système (10) selon la revendication 4, une vitesse de transmission du mode de masse (GM0) étant inférieure à celle du deuxième mode métallique (MM2).

6. Système (10) selon la revendication 1, les première et troisième lignes conductrices (12, 16) étant des lignes extérieures et la deuxième ligne conductrice (14) étant une ligne intermédiaire positionnée entre les première et troisième lignes conductrices (12, 16) ; ou les première et troisième lignes conductrices (12, 16) transmettant des ondes ayant des polarités opposées.

7. Système (10) selon la revendication 1, l'onde de deuxième mode métallique (MM2) se déplaçant uniquement à travers les première et troisième lignes conductrices (12, 16) ; ou
l'onde de premier mode métallique (MM1) parcourant chacune des première, deuxième et troisième lignes conductrices (12, 14, 16) ; ou
le mode de masse (GM0) passant par chacune des première, deuxième et troisième lignes conductrices (12, 14, 16).

8. Système (10) selon la revendication 1, le dispositif de commande (20) pouvant fonctionner pour identifier une ligne défaillante sans traitement préalable des données transmises par les capteurs (22, 24).

9. Système (10) selon la revendication 8, le dispositif de commande (20) étant configuré pour déterminer une ligne conductrice défaillante lors de la détection d'une onde de premier mode métallique (MM1).

10. Système (10) selon la revendication 1,
le ou les capteurs (22, 24) étant configurés pour détecter une tension et un courant circulant dans les première, deuxième et troisième lignes conductrices électriques (12, 14, 16) ;
le dispositif de commande (20) pouvant être utilisé pour identifier l'onde de premier mode métallique (MM1), l'onde de deuxième mode métallique (MM2) et l'onde de mode de masse (GM0) générées par un défaut dans l'une quelconque des première, deuxième et troisième lignes conductrices électriques (12, 14, 16) ;
et
le dispositif de commande (20) étant en outre configuré pour couper l'alimentation électrique d'un ou plusieurs des premier, deuxième ou troisième conducteurs (12, 14, 16) lorsque l'onde de premier mode métallique (MM1) est détectée.

11. Système selon la revendication 10, le dispositif de commande (20) étant configuré pour envoyer un signal de coupure d'alimentation à une ligne conductrice défaillante dans les 10 microsecondes d'une défaillance détectée ; ou
le dispositif de commande (20) étant configuré pour couper l'alimentation d'une ligne conductrice défaillante avant d'effectuer des calculs de processus des données détectées.

12. Procédé (50, 100, 150) comprenant :
la détection (60, 110, 160) d'au moins une onde progressive de tension dans une première ligne conductrice (12), une deuxième ligne conductrice (14) et une troisième ligne conductrice (16) d'un système triphasé (10) ; et
la détermination de laquelle des ondes progressives de tension est une onde de premier mode métallique (MM1), une onde de deuxième mode métallique (MM2) et/ou une onde de mode de masse (GM0),
**caractérisé en ce que**
la détermination qu'au moins une des première et troisième lignes conductrices (12, 16) est défaillante, si l'onde de premier mode métallique (MM1) est détectée sur les première, deuxième et troisième lignes conductrices (12, 14, 16), et si l'onde de deuxième mode métallique (MM2) n'est détectée que sur les première et troisième lignes conductrices (12, 16),
la détermination que la deuxième ligne conductrice (14) est défaillante, si l'onde de premier mode métallique (MM1) est détectée sur les première, deuxième et troisième lignes conductrices (12, 14, 16), et si l'onde de deuxième mode métallique (MM2) n'est pas détectée sur les première, deuxième et troisième lignes conductrices (12, 14, 16) ; et
la coupure (74, 124, 174) de l'alimentation électrique vers l'une quelconque des lignes conductrices (12, 14, 16) déterminée comme étant défaillante.

13. Procédé selon la revendication 12, comprenant en outre les étapes suivantes :
la détection (51, 102, 152) d'une onde progressive de courant dans une première ligne conductrice (12), une deuxième ligne conductrice (14) et une troisième ligne conductrice (16) ; et
la détermination (54, 104, 154) si l'onde progressive de courant se déplace dans une direction directe dans la première ligne conductrice (12), la deuxième ligne conductrice (14) et la troisième ligne conductrice (16) ;
l'alimentation électrique de l'une quelconque des lignes conductrices (12, 14, 16) déterminée comme étant défaillante étant coupée lors de la détermination (54, 104, 154) que l'onde progressive de courant se déplaçant dans la direction avant et que l'onde progressive de tension dépasse une valeur seuil prédéterminée.

14. Procédé selon la revendication 13, comprenant en outre l'envoi d'un signal pour couper l'alimentation électrique dans les 10 microsecondes suivant la détection du défaut ; ou
le défaut étant généré par un court-circuit.

15. Procédé selon la revendication 12, l'onde progressive de tension étant l'une d'une onde progressive de mode métallique 1 (MM1), d'une onde progressive de mode métallique 2 (MM2) et d'une onde progressive de mode de masse 0 (GM0).
